# EUROPEAN PATENT APPLICATION

(11) **EP 2 341 551 A2**
(43) Date of publication of application: **06.07.2011**
(21) Application number: 10193397.6
(22) Date of filing: 01.12.2010
(51) Int. Cl.: H01L 31/0352

(54) **Hybrid solar cells**

(30) Priority: 29.12.2009 US 649155
(71) Applicant: Honeywell International Inc., Morristown, NJ 07962 (US)
(72) Inventor: Liu, Yue, Plymouth, MN 55447 (US); Zheng, Zhi, 200030, Shanghai (CN); Freeman, Alex, Dallas, TX 75287 (US)
(74) Representative: Buckley, Guy Julian

(57) **Abstract**

Solar cells (10, 110) and methods for manufacturing solar cells (10, 110) are disclosed. An example solar cell (10, 110) includes a first electrode (12, 112) and a second electrode (20, 120). A first active layer (16, 116) may be disposed between the first electrode (12, 112) and the second electrode (20, 120), and a second active layer (14, 114) different from the first active layer (16, 116) may also be disposed between the first electrode (12, 112) and the second electrode (20, 120). One or more layers of conductive material (18, 118a, 118b) may be disposed between the first active layer (16, 116) and the second active layer (14, 114), if desired. In some instances, the first active layer (16, 116) may be sensitive to a first range of wavelengths, and the second active layer (14, 114) may be sensitive to a second range of wavelengths, where at least part of the first range of wavelengths does not overlap at least part of the second range of wavelengths. It is contemplated that more than two active layers may be used, if desired.

## Description

### Cross-Reference to Related Application

This application is related to U.S. Patent Application Serial No. 12/484,034, filed June 12, 2009, and entitled QUANTUM DOT SOLAR CELLS, the entire disclosure of which is herein incorporated by reference.

### Technical Field

The disclosure relates generally to solar cells. More particularly, the disclosure relates to solar cells that have an active layer and a quantum dot layer.

### Background

A wide variety of solar cells have been developed for converting sunlight into electricity. Of the known solar cells, each has certain advantages and disadvantages. There is an ongoing need to provide alternative solar cells as well as alternative methods for manufacturing solar cells.

### Summary

The disclosure relates generally to solar cells and methods for manufacturing solar cells. An example solar cell may include a first electrode and a second electrode. A first active layer may be disposed between the first electrode and the second electrode, and a second active layer different from the first active layer may also be disposed between the first electrode and the second electrode. One or more layers of conductive material may be disposed between the first active layer and the second active layer, if desired. In some instances, the first active layer may be sensitive to a first range of wavelengths, and the second active layer may be sensitive to a second range of wavelengths, where at least part of the first range of wavelengths does not overlap at least part of the second range of wavelengths. It is contemplated that more than two active layers may be used, if desired.

The above summary is not intended to describe each disclosed embodiment or every implementation. The Figures and Description which follow more particularly exemplify certain illustrative embodiments.

### Brief Description of the Drawings

The invention may be more completely understood in consideration of the following detailed description of various embodiments of the invention in connection with the accompanying drawings, in which:
Figure 1 is a schematic cross-sectional side view of an illustrative but non-limiting example of a solar cell;
Figure 2 is a schematic cross-sectional side view of an illustrative but non-limiting example of another solar cell;
Figure 3 is a plot of current versus voltage for an illustrative but non-limiting example solar cell; and
Figure 4 is a plot of photon density versus photon energy for an illustrative but non-limiting example solar cell.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the spirit and scope of the invention.

### Description

The following description should be read with reference to the drawings in which similar elements in different drawings are numbered the same. The drawings, which are not necessarily to scale, depict illustrative embodiments and are not intended to limit the scope of the invention.

For the following defined terms, these definitions shall be applied, unless a different definition is given in the claims or elsewhere in this specification.

All numeric values are herein assumed to be modified by the term "about," whether or not explicitly indicated. The term "about" generally refers to a range of numbers that one of skill in the art would consider equivalent to the recited value (i.e., having the same function or result). In many instances, the terms "about" may include numbers that are rounded to the nearest significant figure.

The recitation of numerical ranges by endpoints includes all numbers within that range (e.g. 1 to 5 includes 1, 1.5, 2, 2.75, 3, 3.80, 4, and 5).

As used in this specification and the appended claims, the singular forms "a", "an", and "the" include plural referents unless the content clearly dictates otherwise. As used in this specification and the appended claims, the term "or" is generally employed in its sense including "and/or" unless the content clearly dictates otherwise.

A wide variety of solar cells (which also may be known as photovoltaics and/or photovoltaic cells) have been developed for converting sunlight into electricity. Some example solar cells include a layer of crystalline silicon. Second and third generation solar cells often utilize a thin film of photovoltaic material (e.g., a "thin" film) deposited or otherwise provided on a substrate. These solar cells may be categorized according to the photovoltaic material deposited. For example, inorganic thin-film photovoltaics may include a thin film of amorphous silicon, microcrystalline silicon, CdS, CdTe, Cu₂S, copper indium diselenide (CIS), copper indium gallium diselenide (CIGS), etc. Organic thin-film photovoltaics may include a thin film of a polymer or polymers, bulk heterojunctions, ordered heterojunctions, a fullerence, a polymer/fullerence blend, photosynthetic materials, etc. These are only examples.

Efficiency may play an important role in the design and production of photovoltaics. One factor that may correlate to efficiency is the breadth of the absorption spectrum for the active layer. For example, some active layers absorb photons of light across a relatively small range of wavelengths. Because of this, the efficiency of the solar cell may be limited.

The solar cells disclosed herein are designed to be more efficient by, for example, increasing the breadth of the absorption spectrum so that the solar cells may absorb photons from a wider range of wavelengths. The methods for manufacturing photovoltaics and/or photovoltaic cells disclosed herein are aimed at producing more efficient photovoltaics at a lower cost.

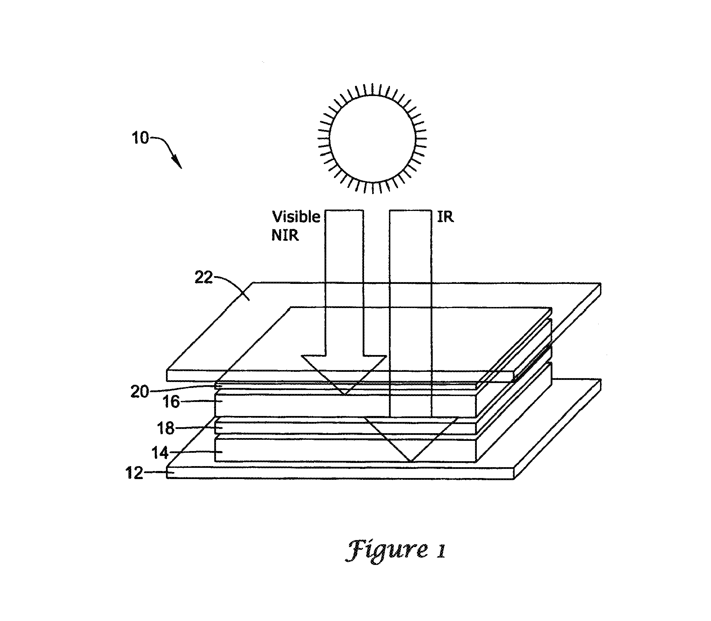

Figure 1 is a schematic cross-sectional side view of an illustrative solar cell 10. In the illustrative embodiment, solar cell 10 may include a substrate or electrode 12. An active layer 14 may be coupled to electrode 12. Another active layer 16 may be coupled to active layer 14. In some instances, a layer 18 such as a conductive layer, may be disposed between active layer 14 and active layer 16. Another layer or electrode 20 may be disposed, for example, on active layer 16. Another substrate 22 may be coupled to electrode 20.

For the sake of convenience, active layer 16 may also be termed the "first" active layer 16 and active layer 14 may be termed the "second" active layer 14. It can be appreciated that the terms "first" and "second" for active layers 14/16 are utilized for convenience as these layers 14/16 may be arranged in a different order or configuration without departing from the spirit of the disclosure. The connections between the various layers of solar cell 10 may be altered to be consistent with the desired ordering or arrangement.

Substrates and/or electrodes 12/20/22 may be made from a variety of materials including polymers, glass, and/or transparent materials. In one example, the substrates/electrodes 12/20/22 may include glass, plastic, polyethylene terephthalate, polyimide, low-iron glass, fluorine-doped tin oxide, indium tin oxide, Al-doped zinc oxide, a transparent conductive oxide, metal foils, other substrates coated with metal (e.g., Al, Au, etc.), any other suitable conductive inorganic element or compound, conductive polymer, and other electrically conductive material, or any other suitable material. Similarly, layers 18/20 may include a conductive material and/or any of the materials listed above as being appropriate for substrates/electrodes 12/20/22. In some embodiments, substrate 22 and electrode 20 may form a unitary structure or layer made from any of the materials disclosed herein.

In an illustrative embodiment, electrode 12 may include a metal foil or substrate coated with metal (e.g., Al, Au, etc.). Active layer 14 may include a photoactive layer that is sensitive to light in the visible and/or near infrared region and/or the infrared region. Layer 18 may be a conductive layer such as indium tin oxide or fluorinated tin oxide. In some instances, active layer 16 may include a photosensitive dye and/or a quantum dot layer that is sensitive to light in the visible and/or near infrared region. Layer 20 may include a transparent conductive oxide such as indium tin oxide or fluorinated tin oxide. Substrate 22 may include a transparent window that may be made from glass or plastic, or any other suitable material.

In some embodiments, solar cell 10 may include one or more electron conductor layers, which may be formed of any suitable material or material combination that is transparent to the wavelengths underlying active. The electron conductor layer(s) may be disposed at any suitable position within solar cell 10 such as adjacent active layer 14 and/or active layer 16. In some instances, the electron conductor layer(s) may be an n-type electron conductor. The electron conductor layer(s) may be metal oxides , such as TiO₂ or ZnO. In some cases, the electron conductor layer may be an electrically conducting polymer, such as a polymer that has been doped to be electrically conducting or to improve its electrical conductivity. In at least some embodiments, the electron conductor layer(s) may be formed or otherwise include a structured pattern or array of, for example, nanoparticles, nanopillars, nanowires, or the like. One or more of the layers of solar cell 10 may include such electron conductors. In some instances, a top surface of electrode 12 and/or a top surface of layer 18 may include an electron conductor layer, if desired.

In some embodiments, the solar cell 10 may include one or more hole conductor layers. The hole conductor layers may include a p-type conductor. One or more of the layers of solar cell 10 may include such hole conductors. For example, and in some cases, the button surface of layer 20 and/or the bottom surface of layer 18 may include a hole conductor.

In some instances, the hole conductor layer(s) may be a conductive polymer, but this is not required. The conductive polymer may, for example, be or otherwise include a functionalized polythiophene. An illustrative but non-limiting example of a suitable conductive polymer has 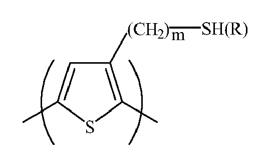 as a repeating unit, where R is absent or alkyl and m is an integer ranging from about 6 to about 12. The term "alkyl" refers to a straight or branched chain monovalent hydrocarbon radical having a specified number of carbon atoms. Examples of "alkyl" include, but are not limited to, methyl, ethyl, n-propyl, isopropyl, n-butyl, s-butyl, t-butyl, n-pentyl, n-hexyl, 3-methylpentyl, and the like.

Another illustrative but non-limiting example of a suitable conductive polymer has 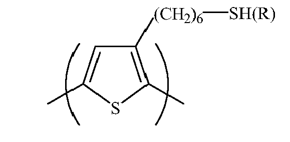 as a repeating unit, where R is absent or alkyl.

Another illustrative but non-limiting example of a suitable conductive polymer has 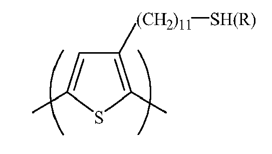 as a repeating unit, where R is absent or alkyl.

Another illustrative but non-limiting example of a suitable conductive polymer has 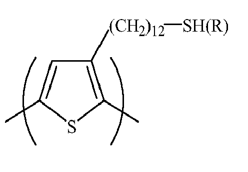 as a repeating unit, where R is absent or alkyl.

As indicated above, solar cell 10 may include a plurality of active layers such as, for example, active layer 14 and active layer 16. In general, active layers 14/16 may be selected so that they are able to generate current in response to a range of wavelengths. For example, first active layer 16 may be sensitive to light across a first range of wavelengths and second active layer 14 may be sensitive to light across a second range of wavelengths that is at least partially different from the first range. Because a broader range of wavelengths may be collected by such a solar cell 10, the overall efficiency may be increased. In some embodiments, solar cell 10 may include three or more active layers.

The particular wavelength ranges that each or layers 14/16 may be sensitive to may vary. Some examples wavelengths for one or both of layers 14/16 may include wavelengths across the visible region, across the infrared region, across the near infrared region, etc. Other wavelength ranges are also contemplated. In one illustrative example, layer 16 may be sensitive to light across the visible and/or near-infrared region and essentially transparent to light in the infrared region. Layer 14 may be sensitive to light in the infrared region.

First active layer 16 and second active layer 14 may be electrically coupled so that current generated from each of the active layers 14/16 may contribute to the overall current output of solar cell 10. In at least some embodiments, active layers 14/16 are electrically coupled in series so that, for example, their respective currents and voltages are additive. Other electrical connections, however, are contemplated including versions where active layers 14/16 are connected in parallel. The electrical connection of active layers 14/16 may be made via layer 18, which may be any suitable conductive material or layer such as indium tin oxide, fluorinated tin oxide, or any other suitable material.

In order for light to be absorbed by both of active layers 14/16, it may be desirable to design layers 14/16 so that light can effectively reach each of the active layers 14/16. Accordingly, it may be desirable for solar cell 10 to be designed so that one of active layers 14/16 is essentially "transparent" to the wavelength of light that is of a lower photon energy (e.g., a longer wavelength) that its absorption bandgap. In general, the transparent layer would be disposed closer to the light source so that light of a longer wavelength can pass through the transparent layer to reach the lower layer. In other words, an effective design for solar cell 10 would likely not include a layer such as an opaque material and/or opaque electrode nearest the light source, as this would tend to block light from reaching one or more of the active layers 14/16.

In some instances, second active layer 14 may be a quantum dot layer. Quantum dots are typically very small semiconductors, having dimensions in the nanometer range. Because of their small size, quantum dots may exhibit quantum behavior that is distinct from what would otherwise be expected from a larger sample of the material. In some cases, quantum dots may be considered as being crystals composed of materials from Groups II-VI, III-V, or IV-VI materials. The quantum dots employed herein may be formed using any appropriate technique. Examples of specific pairs of materials for forming quantum dots include, but are not limited to, MgO, MgS, MgSe, MgTe, CaO, CaS, CaSe, CaTe, SrO, SrS, SrSe, SrTe, BaO, BaS, BaSe, BaTe, ZnO, ZnS, ZnSe, ZnTe, CdO, CdS, CdSe, CdTe, HgO, HgS, HgSe, HgTe, Al₂O₃, Al₂S₃ Al₂Se₃ Al₂Te₃, Ga₂O₃ Ga₂S₃ Ga₂Se₃ Ga₂Te₃ In₂O₃ In₂S₃ In₂Se₃ In_{z}Te₃, SiO₂, GeO₂, SnO₂, SnS, SnSe, SnTe, PbO, PbO₂, PbS, PbSe, PbTe, AIN, AlP, AlAs, AlSb, GaN, GaP, GaAs, GaSb, InN, InP, InAs and InSb.

In some instances, the first active layer 16 may also include a quantum dot layer. Indeed, in some cases first active layer 16 may include a quantum dot layer that is sensitive to light across a different wavelength range than second active layer 14, or otherwise different from second active layer 14. For example, in some cases, second active layer 14 may include CdSe quantum dot layer, which may be sensitive to light having a wavelength of about 300-600 nm, and first active layer 16 may be a quantum dot layer sensitive to light have a different wavelength range.

In other embodiments, first active layer 16 may be another type of photoactive layer. For example, first active layer 16 may include a photosensitive dye or a layer of photosensitive dye. Such a layer may be sensitive to light at other wavelengths such as, for example, wavelengths greater than that of CdSe quantum dots. Furthermore, photosensitive dyes may form a monolayer, for example, on an electron conductor material such as TiO₂. By applying such a layer of photosensitive dye on, for example, electron conductor layer 12, electron-hole recombination may be reduced by reducing "leakage" at the surface of layer 12.

Other configurations and forms for the first and second active layers 14/16 are also contemplated including examples where first layer 16 (and/or second layer 14) may include a thin film of amorphous silicon, microcrystalline silicon, CdS, CdTe, Cu₂S, copper indium diselenide (CIS), copper indium gallium diselenide (CIGS), a thin film of a polymer or polymers, bulk heterojunctions, ordered heterojunctions, a fullerence, a polymer/fullerence blend, photosynthetic materials, etc.

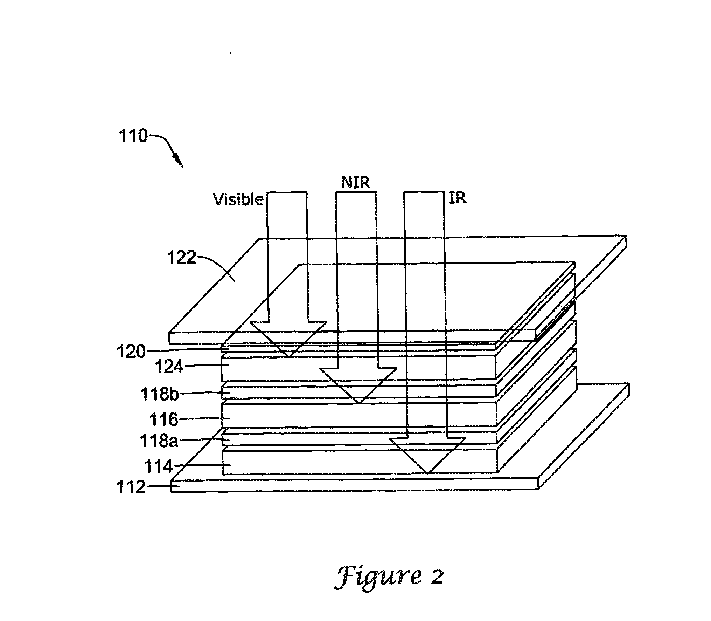

Figure 2 illustrates another example solar cell 110 that is similar in form and function to solar cell 10. Figure 2 illustrates that the disclosed solar cells are not intended to be limited to having any particular number of active layers as solar cells are contemplated that include two active layers (as in Figure 1), three active layer (as in Figure 2), or more active layers. For example, solar cell 110 shown in Figure 2 may include substrate/electrode 112, active layer 114, active layer 116, layer 120 and substrate/electrode 122. Solar cell 110 may also include another active layer 124. Layer 118a may be disposed between active layer 114 and active layer 116. Similarly, layer 118b may be disposed between active layer 116 and active layer 118b. The material composition of any of the structures of solar cell 110 may be similar to analogous structures of solar cell 10.

In one illustrative example, layer 124 may be sensitive to light across the visible and/or near-infrared region (e.g., across the visible region) and essentially transparent to light in the infrared region. Layer 114 may be essentially transparent to light across the visible and/or near-infrared region (e.g., across the near-infrared region) and sensitive to light in the infrared region. Layer 116 may be sensitive to light intermediate to layers 124/114.

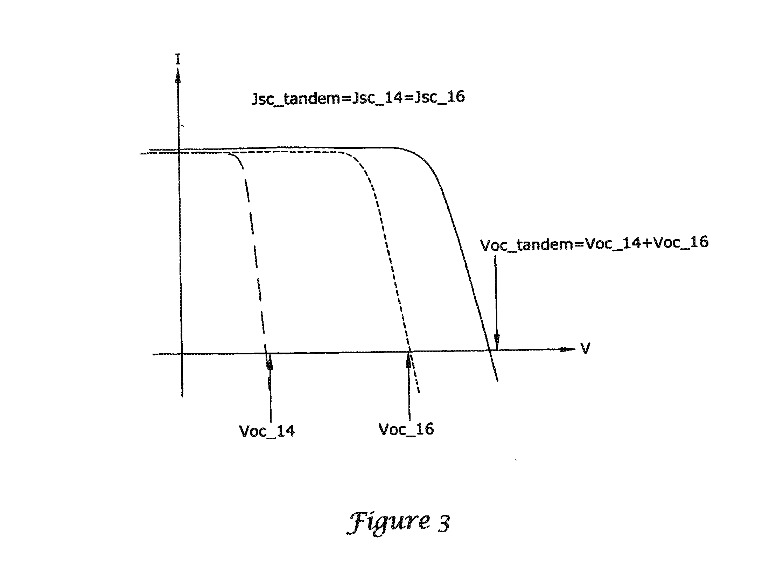

Figure 3 is a plot of current versus voltage for an illustrative but non-limiting example solar cell. In this example, current is plotted versus voltage for solar cell 10 of Figure 1. Here it can be seen that the open circuit voltage for active layer 14 (Voc_14), when combined with the open circuit voltage for active layer 16 (Voc_16), is additive so as to define a tandem open circuit voltage (Voc_tandem). This is because the active layers 14 and 16 are connected in series. The short circuit current densities (J_{sc}) are also kept equal such that the short circuit current density for active layer 14 (Jsc_14) is about equal to the short circuit current density for active layer 16 (Jsc_16), and about equal to the tandem short circuit current density (Jsc_tandem). In one illustrative example, the short circuit current density (e.g., Jsc_tandem) is about 22 mA/cm², but any suitable current density may be used.

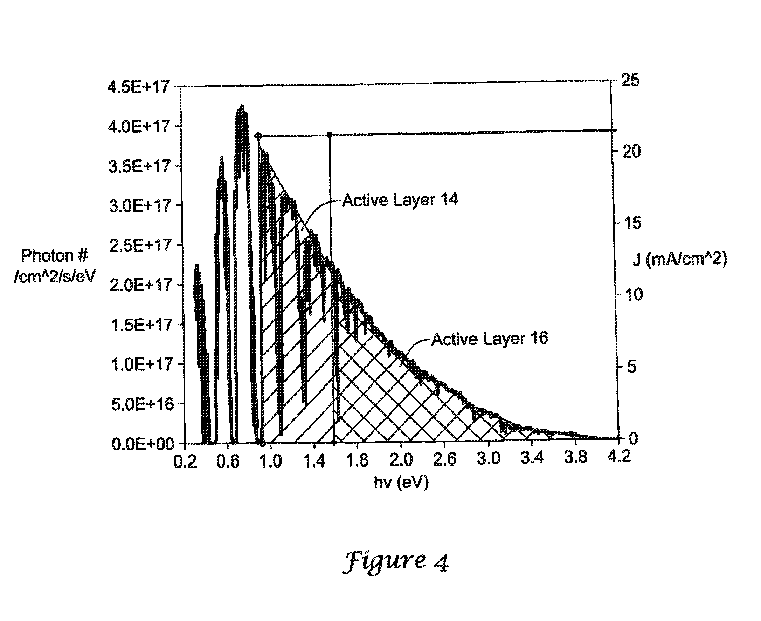

Figure 4 is a plot of photon density versus photon energy for an illustrative but non-limiting example solar cell. Here it can be seen how the active layer 14 is sensitive to light from a first portion of the spectrum (first range of wavelengths), while second active layer 16 is sensitive to light from another part of the spectrum (second range of wavelengths). In this example, active layer 14 is sensitive to light across a portion of the spectrum having longer wavelengths, whereas active layer 16 is sensitive to light across a portion of the spectrum having shorter wavelengths. In some cases, there is some overlap between the wavelength ranges.

While the cells 10/110 disclosed herein are described in terms of solar cells, it should be appreciated that this disclosure is also applicable to other thin-film devices, such as light emitting diodes (LED's) and other devices. Consequently, to the extent applicable, this disclosure may analogously be applied to other thin film structures, as desired.

It should be understood that this disclosure is, in many respects, only illustrative. Changes may be made in details, particularly in matters of shape, size, and arrangement of steps without exceeding the scope of the invention. The invention's scope is, of course, defined in the language in which the appended claims are expressed.

## Claims

1. A solar cell (10, 110), comprising:
a first electrode (12, 112);
a second electrode (20, 120);
a first active layer (16, 116) disposed between the first electrode (12, 112) and the second electrode (20, 120);
a second active layer (14, 114) different from the first active layer (16, 116) disposed between the first electrode (12, 112) and the second electrode (20, 120).

2. The solar cell (10, 110) of claim 1, further comprising a layer (18, 118a, 118b) of conductive material disposed between the first active layer (16, 116) and the second active layer (14, 114).

3. The solar cell (10, 110) of any one of claims 1-2, wherein the second active layer (14, 114) includes a quantum dot layer.

4. The solar cell (10, 110) of any one of claims 1-3, wherein the first active layer (16, 116) includes a quantum dot layer.

5. The solar cell (10, 110) of any one of claims 1-4, wherein the first active layer (16, 116) is sensitive to light across a first range of wavelengths, and the second active layer (14, 114) is sensitive to light across a second range of wavelengths different from the first range of wavelengths.

6. The solar cell (10, 110) of claim 6, wherein the first range of wavelengths falls within the infrared region, within the near infrared region, or within the visible region.

7. The solar cell (10, 110) of any one of claims 1-6, wherein the first active layer (16, 116) includes a photosensitive dye.

8. The solar cell (10, 110) of any one of claims 1-7, wherein the first active layer (16, 116) and the second active layer (14, 114) are electrically coupled in series.

9. The solar cell (10, 110) of any one of claims 1-8, further comprising one or more additional active layers (124).

10. A method for manufacturing a solar cell (10, 110), the method comprising:
providing a first electrode (12, 112);
disposing an active layer (14, 114) on the first electrode (12, 112);
disposing a conductive layer (18, 118a) on the active layer (14, 114);
disposing a quantum dot layer (16, 116) on the conductive layer (18, 118a);
wherein the active layer (14, 114) is sensitive to light across a first range of wavelengths and the quantum dot layer (16, 116) is sensitive to light across a second range of wavelengths different from the first range of wavelengths; and
disposing a second electrode (20, 120) adjacent to the quantum dot layer (16, 116).
